Europäisches Patentamt

European Patent Office

Office européen des brevets

(11) Veröffentlichungsnummer: **0 099 415**
**A1**

(12) **EUROPÄISCHE PATENTANMELDUNG**

(21) Anmeldenummer: 82106466.4

(22) Anmeldetag: 17.07.82

(51) Int. Cl.³: **H 03 K 4/50**
G 01 N 29/04, G 01 S 7/62
G 01 R 13/32

(43) Veröffentlichungstag der Anmeldung:
01.02.84 Patentblatt 84/5

(84) Benannte Vertragsstaaten:
DE FR GB

(71) Anmelder: **Krautkrämer GmbH**
**Luxemburger Strasse 449**
**D-5000 Köln 41(DE)**

(72) Erfinder: **Rutloh, Max**
**Disternicherweg 22**
**D-5042 Erfstadt(DE)**

(54) **Schaltvorrichtung zur Erzeugung von Zägezahnimpulsen und Verwendung derartiger Schaltungsvorrichtungen in Ultraschallmessgeräten.**

(57) Es wird eine Vorrichtung zur Einstellung der Hinlaufzeit einer Kippspannung, insbesondere für die Anwendung in Ultraschallgeräten, beschrieben, Bei dieser Einstellung werden drei voneinander unabhängige Parameter berücksichtigt, der Einschallwinkel, die Schallausbreitungsgeschwindigkeit und die Prüfstückdicke. Hierzu wird die quarzstabilisierte Frequenz eines Oszillators (8) mit einem dritten einstellbaren Frequenzteiler (7) durch den Winkelfunktionswert des eingestellten Winkels dividiert. Die geteilte Frequenz wird einem Frequenzvervielfacher (10) in PLL-Schaltung zugeführt, der einen ersten einstellbaren Frequenzteiler (6) enthält, mit dem die Schallausbreitungsgeschwindigkeit eingestellt wird. In der folgenden Zeitreferenzstufe (3) ist ein zweiter einstellbarer Frequenzteiler (2) enthalten, mit dem die Prüfstückdicke eingestellt wird. Die von der Referenzstufe (3) erzeugten Recteckimpulse berücksichtigen in ihrer Dauer die drei eingestellten Parameter mit der gleichen relativen Genauigkeit, wie vom quarzstabilisierten Oszillator (8) vorgegeben. Die Dauer des von der Referenzstufe erzeugten Rechteckimpulses ist gleich der Hinlaufzeit.

FIG.1

0099415
16. Juli 1982
Kw/Cl
K-164

Krautkrämer GmbH
Luxemburger Str. 449
5000  Köln 41

### SCHALTUNGSVORRICHTUNG ZUR ERZEUGUNG VON ZÄGEZAHN-IMPULSEN UND VERWENDUNG DERARTIGER SCHALTUNGSVOR-RICHTUNGEN IN ULTRASCHALLMESSGERÄTEN

---

Die Erfindung betrifft eine Schaltungsvorrichtung zur Erzeugung von Sägezahnimpulsen mit einstellbarer Hinlaufzeit, bei der eine spannungsabhängige Konstantstromquelle, einen Integrationskreis und eine Komparatorschaltung enthaltender Kippgenerator  jeweils durch Impulse eines Triggers ausgelöst wird. Die Erfindung bezieht sich ferner auf eine Verwendung derartiger Schaltungsvorrichtungen in Ultraschall-Meßgeräten, wie sie vorzugsweise für die zerstörungsfreie Werkstoffprüfung benutzt werden.

Eine derartige Schaltungsvorrichtung ist beispielsweise aus der US-PS 3.577.007 für die Prüfung von Verbrennungsmotoren bekannt. Dabei wird die an den Kippkondensatoren anliegende Spannung integriert und in einem Komparator während der vorgegebenen Triggerzeit mit einem Sollwert verglichen. Bei Abweichung vom vorgegebenen Sollwert bewirkt die Differenzspannung eine Steuerung der Konstantstrom-Quelle, so daß die Hinlaufzeit, das ist die Dauer des für die Zeilenablenkung benutzten Teil des Sägezahnimpulses, angenähert kontant bleibt.

Nachteilig ist bei dieser Schaltungsvorrichtung, daß der mögliche Regelbereich der Hinlaufzeit sehr eingeengt ist, weil lediglich ein einziger Kondensator verwendet wird. Außerdem kann man die Rücklaufzeit der Sägezahnimpulse nicht beliebig klein wählen, weil während dieser Zeit der Soll-Ist-Wert-Vergleich erfolgt. Ferner läßt sich dieser Schrift auch nicht entnehmen, auf welche Weise mit mehreren voneinander unabhängigen Parametern die Hinlaufzeit definiert werden kann.

Aus der DE-OS 29 45 200 ist ferner eine Schaltungsvorrichtung zum
Erzeugen von Sägezahnimpulsen für Ultraschall-Prüfgeräte bekannt, bei
der die Hinlaufzeit mit Hilfe digitaler Schaltungselemente auf einen
Konstantwert geregelt werden kann. Der Soll-Ist-Wert-Vergleich erfolgt
dabei vorzugsweise mit Hilfe eines Mikroprozessors.

Bei dieser Schaltungsvorrichtung ist vor allem nachteilig, daß zwischen
der Einstellung der Hinlaufzeit und dem entsprechend sich ergebenden
Sägezahnimpuls eine relativ lange Zeit vergeht, weil die verwendeten
Bauelemente in der Regel nicht schnell genug arbeiten bzw. entsprechend
schnell arbeitende Bauelemente sehr teuer sind, z.B. A/D-Wandler.

Der vorliegenden Erfindung liegt die Aufgabe zugrunde, eine einfache
genau und schnell arbeitende Schaltungsvorrichtung der eingangs erwähnten Art anzugeben.

Die vorstehende Aufgabe wird erfindungsgemäß durch die Merkmale der
kennzeichnenden Teile des Anspruchs 1 gelöst. Die weiteren Unteransprüche geben eine vorteilhafte Ausgestaltung bzw. eine bevorzugte
Verwendung der Erfindung wieder.

Besondere Vorteile der Erfindung sind, das voneinander getrennte
Eingeben von Parameterwerten ohne Verwendung von Kalibrierstücken.
Ferner die Stabilisierung eines die Hinlaufzeit bestimmenden Rechteckimpulses durch einen frequenzstabilisierten Impulsgenerator
(Quarzstabilisierung der Hinlaufzeit), sowie ein einfacher und
kostengünstiger Aufbau ohne Einsatz von Mikroprozessoren oder
A/D-Wandlern.

Weitere Vorteile und Einzelheiten der Erfindung ergeben sich aus dem Ausführungsbeispiel, das mit Hilfe der Figuren 1 bis 4 erläutert wird.

Es zeigen:

Fig. 1:   ein Blockschaltbild eines Ausführungsbeispiels der Erfindung

Fig. 2:   Die Verwendung eines zusätzlichen fest eingestellten Frequenzteilers.

Fig. 3:   Ein Blockschaltbild, das eine Verwendung der erfindungsgemäßen Schaltungsvorrichtung in einem Ultraschall-Prüfgerät zeigt.

Fig. 4:   Ein zu prüfendes Werkstück mit Prüfkopf sowie die für die Prüfung einzustellenden Parameter .

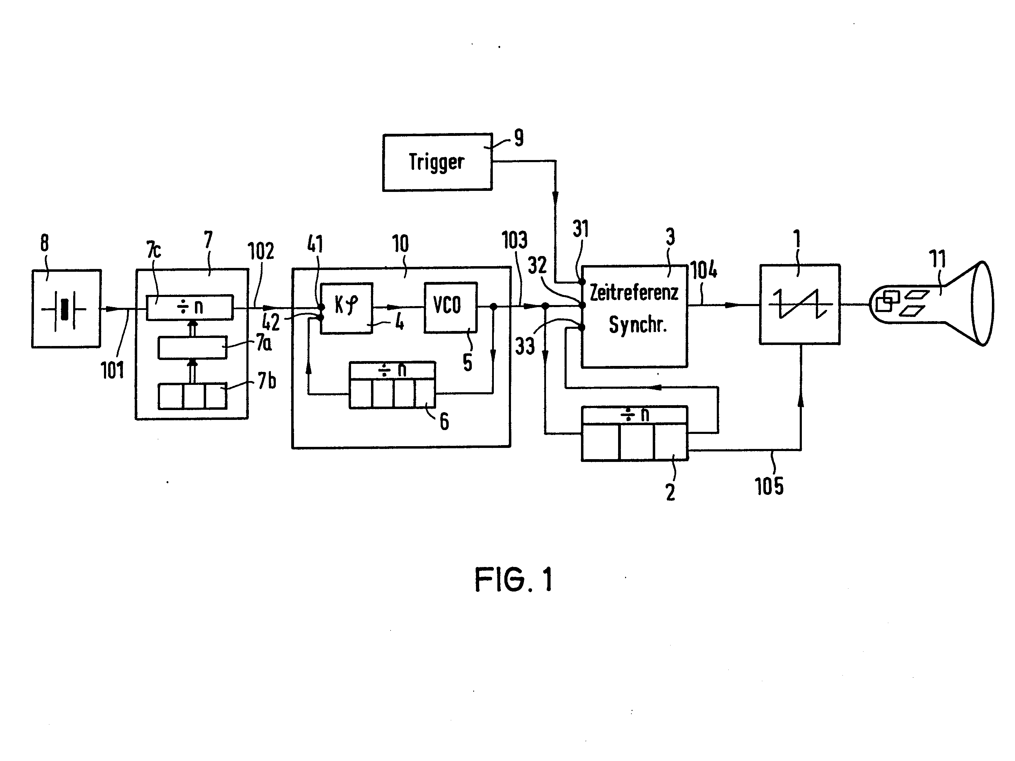

Mit der Fig. 1 wird eine vorteilhafte Ausführung der Erfindung beschrieben. Hier ist mit 1 der Kippgenerator zur Erzeugung der Sägezahnimpulse für die Zeitablenkung des Kathodenstrahls einer Kathodenstrahlröhre 11 bezeichnet. Dem Kippgenerator 1 ist eine Zeitreferenzstufe 3 vorgeschaltet, die Rechteckimpulse erzeugt, deren Dauer dem Sollwert der Hinlaufzeit entsprechen. An dem ersten Eingang 31 dieser Zeitreferenzstufe ist der Trigger 9 angeschlossen. An dem zweiten Eingang 32 der Zeitreferenzstufe 3 ist mit Leitung 103 der als zweites frequenztransformierende Glied bezeichnete Frequenzvervielfacher 10 angeschlossen.

Dieser Frequenzvervielfacher 10 besteht in dieser Ausführungsform aus einem Phasenkomparator 4, dem ein spannungsgesteuerter Oszillator 5 nachgeschaltet ist. Die vom spannungsgesteuerten Oszillator 5 erzeugte Frequenz wird dem ersten einstellbaren Frequenzteiler 6 zugeführt und die geteilte Frequenz an den Phasenkomparator (Eingang 42) zurückgeführt. Diese Schaltung des Frequenzvervielfachers ist an sich als Phasenregelkreis (PLL) bekannt.

Ebenfalls an den zweiten Eingang 32 der Zeitreferenzstufe 3 ist ein zweiter einstellbarer Frequenzteiler 2 angeschlossen, der die geteilte Frequenz zu der Referenzstufe 3 an den Anschluß 33 zurückführt.

An den Eingang des Frequenzvervielfachers 10 ist mit der Leitung 102 der als erstes frequenztransformierendes Glied bezeichnete dritte einstellbare Frequenzteiler 7 angeschlossen. Dieser dritte einstellbare Frequenzteiler besteht in einer vorteilhaften Ausführungsform aus einem Codierschalter 7 b zur Wahl von Zahlenwerten, einem Festwertspeicher 7a, der die mit dem Codierschalter 7b gewählten Zahlenwerte entsprechend mathematischer Beziehungen (z.B. trigonometrische Funktionswerte für gewählte Winkel) in Teilerverhältnisse für die eigentliche Frequenzteilende Schaltungseinheit 7c umsetzt. An den Eingang dieses ersten einstellbaren Frequenzteilers 7 ist der frequenzstabilisierte Impulsgenerator 8 mittels Leitung 101 angeschlossen.

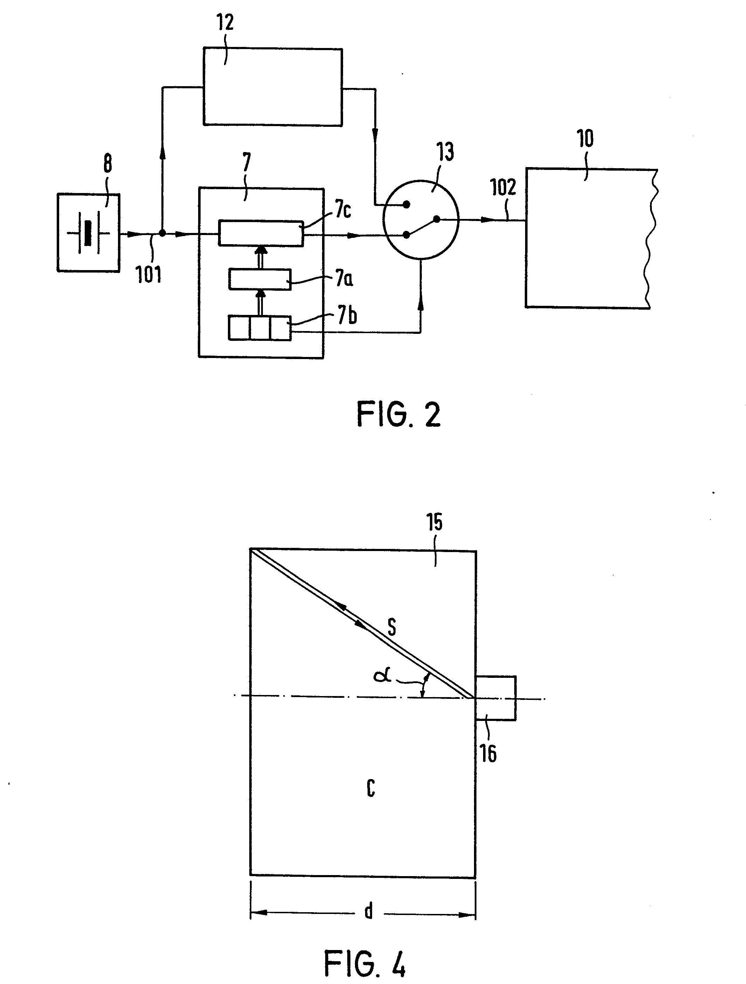

Dem dritten einstellbaren Frequenzteiler 7 kann, wie Fig. 2 zeigt, noch ein fest eingestellter Frequenzteiler 12 parallel geschaltet werden, so daß bei einem bestimmten, mit dem Codierschalter 7b eingestellten, Zahlenwert der einstellbare Frequenzteiler 7 durch den fest eingestellten Frequenzteiler 12 ersetzt wird. Diese Umschaltung erfolgt beispielsweise mit dem elektronischen Umschalter 13.

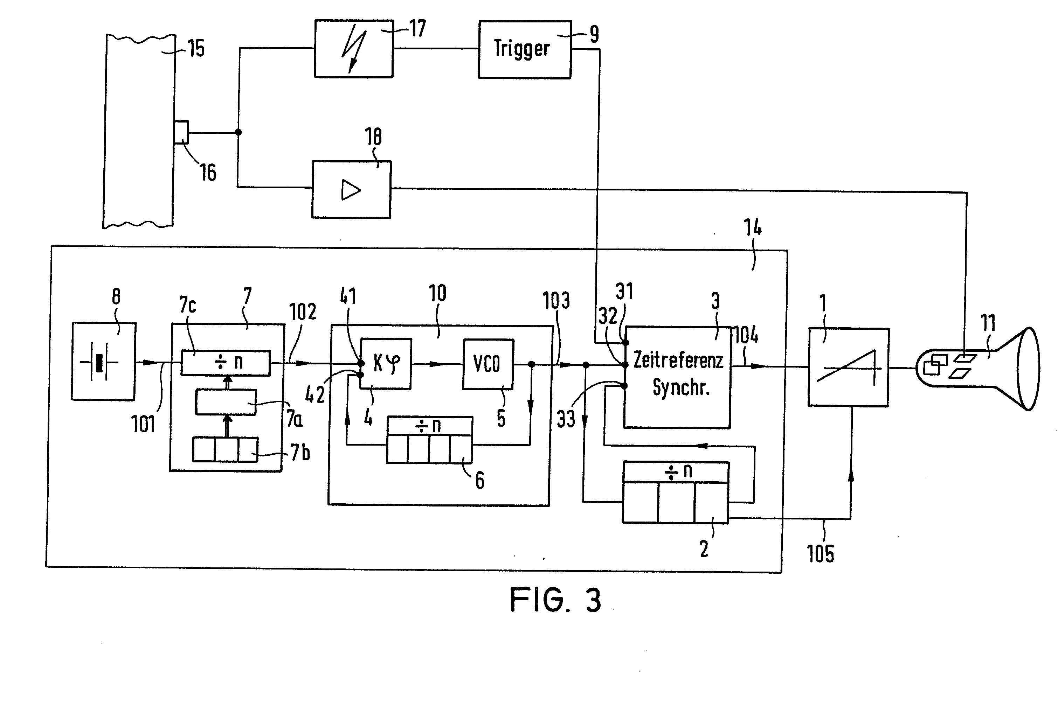

Ein bevorzugtes Verwendungsbeispiel der erfindungsgemäßen Schaltungsvorrichtung nach Fig. 1 in einem Ultraschallprüfgerät wird in der Fig. 3 dargestellt. Die Schaltungsvorrichtung nach Fig. 1 mit den Blöcken 2,3,7,8 und 10 ist in Fig. 3 im Block 14 als einstellbarer Sollwertgeber für die Hinlaufzeit zusammengefaßt. Außer dieser erfindungsgemäßen Schaltungsvorrichtung 14 ist ein Prüfstück 15 mit einem schallmäßig angekoppelten Prüfkopf 16 gezeigt. Der Prüfkopf 16 wird durch den Ultraschallsender 17 zum Aussenden von Ultraschallimpulsen angeregt. Dieser Prüfkopf empfängt auch die aus dem Prüfstück reflektierten Ultraschalldrucksignale und wandelt sie in elektrische Ultraschallsignale um. Diese elektrischen Ultraschallsignale werden in einem Verstärker 18 verstärkt und den Meßplatten einer Kathodenstrahlröhre 11 zugeführt. Der Trigger 9 triggert sowohl den Ultraschallsender 17 als auch die erfindungemäße Schaltungsvorrichtung 14, die die Hinlaufzeit für die Erzeugung des Sägezahnimpulses im Kippgenerator 1 bestimmt. Weitere Schaltungsteile eines üblichen Ultraschall-Prüfgerätes sind nicht gezeichnet.

Im folgenden wird die Funktion der in den Figuren 1 und 2 wiedergegebenen erfindungsgemäßen Schaltungsvorrichtung in der vorteilhaften Verwendung entsprechend Fig. 3 näher beschrieben.Zur Vereinfachung der Wirkungsweise sei angenommen, daß der Trigger 9 gleichzeitig den Sendeimpuls im Sender 17 und den Start der Hinlaufzeit auslöst.

Die Hinlaufzeit des Sägezahnimpulses für die Zeitablenkung soll in dieser Funktionsbeschreibung der Laufzeit des Ultraschallimpulses im Prüfstück 15 entsprechen. Diese Hinlaufzeit ist aber abhängig von der Schallausbreitungsgeschwindigkeit "c" im Material des Prüfstückes, von der Dicke "d" des Prüfstücks und vom Einschallwinkel "$\alpha$". Die Fig. 4 skizziert diese Größen, wobei zu berücksichtigen ist, daß bei der Impuls-Echo-Technik der Schall eine Wegstrecke im Prüfstück hin und zurück, also zweimal, zurücklegt. Die Hinlaufzeit ist also in diesem Beispiel auf drei Parameter, dem Winkel $\alpha$, der Schallausbreitungsgeschwindigkeit c und der Prüfstücksdicke d einzustellen, entspechend der Beziehung:

$$ t = \frac{2\,s}{c} = \frac{2\,d}{c \cdot \cos \alpha} $$

Es erscheint zweckmäßig, bei der Funktionsbeschreibung mit dem frequenzstabilisierten Impulsgenerator 8 zu beginnen. Der Impulsgenerator 8, vorzugsweise ein quarzstabilisierter Impulsgenerator, erzeugt Rechteckimpulse mit einer Periodendauer von z.B. 184 µs, entsprechend einer Frequenz von ca. 5,435 KHz. Diese Impulse werden über die Leitung 101 dem als dritten einstellbaren Frequenzteiler 7 bezeichneten Frequenzteiler zugeführt. In diesem werden diese Impulse entsprechend dem Cosinus des Einschallwinkels $\alpha$ in ihrer zeitlichen

Dauer verändert. Die Einstellung des Einschallwinkels kann mit einem dreistelligen Kodierschalter 7b erfolgen, wobei es in der Praxis genügt, die Winkel in 0,5⁰-Schritten abzustufen. Die Werte der Winkelfunktionen werden aus einem Festwertspeicher 7a abgerufen und der Frequenzteiler-Schaltungseinheit 7c zugeführt. Verändert man z.B. den Einschallwinkel von 30,0⁰ bis 80,0⁰, ist die Impulsdauer um das Verhältnis $\cos 30{,}0^{\circ} / \cos 80{,}0^{\circ} \approx 5{:}1$ bzw. die Frequenz um das Verhältnis 1:5 zu variieren. Für den Einschallwinkel 0⁰, also der Senkrechteinschallung, ist der Wert $\cos \alpha = 1$ im einstellbaren Frequenzteiler 7 zu berücksichtigen.

In diesem Ausführungsbeispiel wird die auf der Leitung 101 vorhandene Frequenz von 5,435 KHz für den Einschallwinkel 0⁰ zunächst durch einen Grundfaktor = 45 dividiert. Damit ist für diesen Einschallwinkel auf der Leitung 102 also am Ausgang des einstellbaren Frequenzteilers 7 eine Frequenz von 121 Hz, das entspricht einer Periodendauer von 8,28 µs, vorhanden. Bei 30⁰ Einschallwinkel ist auf der Leitung 102 eine Frequenz von 121 Hz x cos 30⁰ = 104,6 Hz, das entspricht einer Periodendauer von 9,56 µs, und bei 80⁰ Einschallwinkel eine Frequenz von 121 Hz x cos 80⁰ = 21 Hz, das entspricht einer Periodendauer von 48 µs, vorhanden. In der Impulsfrequenz auf der Leitung 102 also am Eingang des Frequenzvervielfachers 10 bzw. in der Periodendauer dieser Impulse ist somit der Einschallwinkel als erster einstellbarer Parameter berücksichtigt.

Im Frequenzvervielfacher 10 wird aus den auf Leitung 102 vorhandenen Impulsfolgen auf der Leitung 103 eine Impulsfolge höherer Frequenz erzeugt. Diese höhere Frequenz ist entsprechend der Arbeitsweise der Frequenzvervielfacher mit Phasenregelkreis um das Frequenzteilerverhältnis des einstellbaren Frequenzteilers 6 höher als die Frequenz auf Leitung 102 am Eingang des Frequenzvervielfachers. Der Wert dieser höheren Frequenz ergibt sich aus folgender Betrachtung:

Bei 0° Einschallwinkel, einer Schallausbreitungsgeschwindigkeit von 8000 m/s und für einen Meßbereich von 5 mm, das entspricht einen Impulslaufweg von 10 mm, ist als Hinlaufzeit eine Periodendauer der Impulse auf Leitung 103 von t = $10 \cdot 10^{-3}$ m/ 8000 m/s = 1,25 µs notwendig. Bei einer Schallausbreitungsgeschwindigkeit von 2000 m/s ist eine Impulsdauer von 5 µs bei gleichem Impulslaufweg notwendig. Für die anderen Einschallwinkel ergeben sich entsprechend dem cos $\alpha$ längere Impulsdauern. Diese werden aber bereits im Frequenzteiler 7 wie beschrieben gebildet. Mit dem im Frequenzvervielfacher 10 enthaltenen einstellbaren Frequenzteiler 6 kann die Schallausbreitungsgeschwindigkeit eingestellt werden. In diesem Beispiel zwischen 2000 m/s und 8000 m/s auf 1 m/s genau, also 4stellig. Auf der Leitung 103 ist demzufolge eine Periodendauer der Impulse vorhanden, in der bereits zwei Parameter berücksichtigt sind, nämlich der Einschallwinkel und die Schallausbreitungsgeschwindigkeit. Die Impulsfolgen mit den so festgelegten Frequenzen bzw. Periodendauern, werden der Zeitreferenzstufe 3 zugeführt. Diese Zeitreferenzstufe beginnt mit jedem Triggervorgang, ausgelöst vom Trigger 9, einem Gleichspannungsimpuls und beendet ihn nach Ablauf der Periodendauer des Impulses am Ausgang des Frequenzvervielfachers 10, auf der Leitung 103. Die Synchronisation der Vorderflanke des Gleichspannungsimpulses mit dem Triggerimpuls erfolgt in der für die Kathodenstrahloszilloskop-Technik bekannten Art. Dieser Gleichspannungsimpuls wird dem Kippgenerator 1 zugeführt. Zur Einstellung eines dritten Parameters, dem vorgebbaren Prüfstückdickenbereich, wird die Impulsfolge auf der Leitung 103 einem weiteren als zweiten einstellbaren Frequenzteiler 2 bezeichneten Frequenzteiler zugeführt. Für 5 mm-Meßbereich ist dessen Teilerverhältnis in diesem Beispiel 1:1 und für 5 m-Meßbereich ist dessen Teilerverhältnis 1:1000, so daß in diesem Verhältnis die Periodendauer der Impulse auf der Leitung 103 verändert werden kann. Die Impulse auf der Leitung 104, also die dem Kippgenerator 1 zugeführten Impulse, berücksichtigen demzufolge auch diesen dritten Parameter. Der Frequenzteiler 2 ist in diesem Beispiel so ausgelegt, daß für den Meßbereich 5 mm mit jedem Triggervorgang eine auf Leitung 103 vorhandene Impulsfolge, ungeteilt dem Kippgenerator 1 zugeführt wird und bei 5 m Meßbereich die Hinlaufzeit durch die Frequenzteilung um den Faktor 1000 länger ist.

Die folgende Tabelle gibt die Grenzwerte bei der Wahl der drei Parameter in ihren Verstellgrenzen an:

Hinlaufzeit für :

| Einschallwinkel | Schallausbreitungs-geschwindigkeit | Meßbereich 5 mm | Meßbereich 5 m |
|---|---|---|---|
| $0^o$ | 8000 m/s<br>2000 m/s | 1,25 µs<br>5 µs | 1,25 ms<br>5 ms |
| $30^o$ | 8000 m/s<br>2000 m/s | 1,44 µs<br>5,77 µs | 1,44 ms<br>5,77 ms |
| $80^o$ | 8000 m/s<br>2000 m/s | 7,2 µs<br>28,8 µs | 7,2 ms<br>28,8 ms |

Bei dem einstellbaren Teilerverhältnis von 1:1000 für den einstellbaren Frequenzteiler 2 und die damit verbundene Veränderung der Hinlaufzeit um das gleiche Verhältnis, müßte auch die im Kippgenerator 1 vorhandene spannungsgesteuerte Konstantstromquelle den Strom für die Kippkondensatoren im gleichen Verhältnis steuern. Um die damit verbundenen Schwierigkeiten zu vermeiden, ist es vorteilhaft, mit der Umschaltung des Teilerverhältnisses des Frequenzteilers 2 auch die Kippkondensatoren umzuschalten, das geschieht über die Leitung 105 in an sich bekannter Weise.

Da allgemein in der Ultraschalltechnik entweder senkrecht ($0^o$ Einschallwinkel) in das Prüfstück eingeschaltet wird oder Einschallwinkel zwischen 30 und $80^o$ verwendet werden, ist es vorteilhaft, wie in Fig. 2 dargestellt, den einstellbaren Frequenzteiler 7 nur für die Winkelfunktionen dieser Winkel zwischen 30 und $80^o$ auszulegen und dementsprechened auch im Festwertspeicher 7a nur diese Werte abzulegen. Für den Einschallwinkel von $0^o$ (Senkrechteinschallung) wird dann mit einem Umschalter 13, vorzugsweise ein elektronischer Umschalter, z.B. ein ODER-Tor, bei der Wahl des $0^o$-Winkels auf den festeingestellten Frequenzteilers 12 umgeschaltet.

**0099415**

16. Juli 1982

Kw/Cl

K-164

Krautkrämer GmbH

Luxemburger Str. 449

5000  Köln 41

P a t e n t a n s p r ü c h e

1.  Schaltungsvorrichtung zur Erzeugung von Sägezahnimpulsen mit einstellbarer Hinlaufzeit, bei der eine spannungsabhängige Konstantstromquelle,
einen Integrationskreis und eine Komparatorschaltung enthaltender
Kippgenerator  jeweils durch Impulse eines Triggers ausgelöst wird,

d a d u r c h  g e k e n n z e i c h n e t ,

- daß zur Erzeugung von die Hinlaufzeit der Sägezahnimpulse bestimmenden Rechteckimpulsen eine Zeitreferenzstufe (3) vorgesehen
  ist, deren Ausgang mit dem Eingang des Kippgenerators verbunden
  ist,

- daß der erste Eingang (31) der Zeitreferenzstufe (3) mit dem
  Trigger (9) verbunden ist, dessen Impulse den jeweiligen Beginn
  der Rechteckimpulse bestimmen und

- daß zur Festlegung des jeweiligen Endes der Rechteckimpulse der
  zweite Eingang (32) der Zeitreferenzstufe (3) über frequenztransformierende Glieder (7;10) mit einem frequenzstabilisierten
  Impulsgenerator (8) verbunden ist.

2.  Schaltungsvorrichtung nach Anspruch 1,

    d a d u r c h  g e k e n n z e i c h n e t ,

    daß zur Einstellung der Hinlaufzeit auf einen dritten Parameter
    zwischen dem frequenzstabilisierten Impulsgenerator (8) und der
    Zeitreferenzstufe (3) ein dritter einstellbarer Frequenzteiler (7)
    als ein erstes frequenztranformierendes Glied vorhanden ist.

3. Schaltungsvorrichtung nach Anspruch 1,

   d a d u r c h   g e k e n n z e i c h n e t ,

   daß zur Einstellung der Hinlaufzeit auf einen ersten Parameter zwischen dem frequenzstabilisierten Impulsgenerator (8) und der Zeitreferenzstufe (3) ein Frequenzvervielfacher (10) als zweites frequenztransformierendes Glied vorhanden ist.

4. Schaltungsvorrichtung nach Anspruch 1,

   d a d u r c h   g e k e n n z e i c h n e t ,

   daß zur Einstellung der Hinlaufzeit auf einen zweiten Parameter an der Zeitreferenzstufe (3) ein zweiter einstellbarer Frequenzteiler (2) derart angeschlossen ist, daß die von der Zeitreferenzstufe (3) gebildeten Rechteckimpulse um das eingestellte Teilerverhältnis des Frequenzteilers (2) länger sind als die am zweiten Eingang (32) der Zeitreferenzstufe (3) vorhandenen Impulse.

5. Schaltungsvorrichtung nach Anspruch 1 und 2,

   d a d u r c h   g e k e n n z e i c h n e t ,

   daß der dritte einstellbare Frequenzteiler (7) aus einem Codierschalter (7b), einem Festwertspeicher (7a) für trigonometrische Funktionen und einer frequenzteilenden Schaltungseinheit (7c) besteht, derart, daß die frequenzteilende Schaltungseinheit (7c) die dem einstellbaren Frequenzteiler (7) zugeführte Frequenz durch den Codierschalter (7b) aus dem Festwertspeicher (7a) abgerufenen Funktionswert teilt.

6. Schaltungsvorrichtung nach Anspruch 1, 2 und 5,

   d a d u r c h   g e k e n n z e i c h n e t ,

   daß zusätzlich zum dritten einstellbaren Frequenzteiler (7) ein fest eingestellter Frequenzteiler (12) vorhanden ist, wobei einer der Frequenzteiler (7;12) wahlweise eingeschaltet wird.

7. Schaltungsvorrichtung nach Anspruch 1 und 3,

   d a d u r c h   g e k e n n z e i c h n e t ,

   daß der Frequenzvervielfacher (10) aus einer Phasenregelkreisschaltung (PLL) besteht, die einen Phasenkomparator (4), dem ein
   spannungsgesteuerter Oszillator (5) nachgeschaltet ist und den
   ersten einstellbaren Frequenzteiler (6), der am Ausgang des
   spannungsgesteuerten Oszillators (5) angeschlossen ist, enthält,
   wobei an einem ersten Eingang (41) des Phasenkomparators (4) die
   von dem frequenzstabilisierten Impulsgenerator (8) abgeleiteten
   Impulse anliegen und an einem zweiten Eingang (42) der Ausgang des
   ersten  einstellbaren Frequenzteilers (6) angeschlossen ist.

8. Verwendung der Schaltungsanordnung nach den Ansprüchen 1 bis 7
   in Ultraschallmeßgeräten, derart,

   - daß mit dem ersten Parameter die Schallausbreitungsgeschwindigkeit im Prüfstück eingestellt wird und

   - daß mit dem zweiten Parameter die Dicke des Prüfstücks eingestellt wird,

   - daß mit dem dritten Parameter der Einschallwinkel des Ultraschallstrahles im Prüfstück eingestellt wird.

FIG. 1

FIG. 2

FIG. 4

0099415

FIG. 3

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y,D | DE-A-2 945 200 (KRAUTKÄMER) <br> * Insgesamt * | 1,8 | H 03 K 4/50 <br> G 01 N 29/04 <br> G 01 S 7/62 <br> G 01 R 13/32 |
| Y | ELECTRONICS, Band 46, Nr. 2, 18. Januar 1973, Seite 170, New York, USA <br> D.M. BROCKMAN: "Synchronous ramp generator maintains output linearity" * Insgesamt * | 1 | |
| A | INSTRUMENTS AND EXPERIMENTAL TECHNIQUES, Band 18, Nr. 1II, Januar-Februar 1975, Seiten 185-186, New York, USA <br> A.G. GOLOVKO et al.: "An adjustable sawtooth-voltage generator" * Insgesamt * | 1 | |
| A | DE-A-1 462 739 (HOWALDTSWERKE-DEUTSCHE WERFT AG) <br> * Figuren 1,2; Seite 5, Zeile 27 - Seite 8, Zeile 10 * | 1 | RECHERCHIERTE SACHGEBIETE (Int. Cl. ³) <br><br> H 03 K <br> G 01 N <br> G 01 S <br> G 01 R |
| A | IBM TECHNICAL DISCLOSURE BULLETIN, Band 24, Nr. 7A, Dezember 1981, Seiten 3492-3493, New York, USA <br> S. PICARD: "Circuit allowing oscilloscopes to be automatically adjusted" * Insgesamt * <br><br> --- -/- | 1 | |

Der vorliegende Recherchenbericht wurde für alle Patentansprüche erstellt.

| Recherchenort <br> DEN HAAG | Abschlußdatum der Recherche <br> 06-04-1983 | Prüfer <br> GYSEN L.A.D. |
|---|---|---|

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | ELECTRONIQUE ET APPLICATION INDUSTRIELLE, Nr. 254, Juni 1978, Seiten 45-47, Paris, FR. G. JEANSAUME: "Réalisation d'un synthétiseur de fréquence en CMOS à alimentation autonome" * Figur 1; Seite 47, linke Spalte * ----- | 1,3,7 | |

RECHERCHIERTE SACHGEBIETE (Int. Cl. ³)

Der vorliegende Recherchenbericht wurde für alle Patentansprüche erstellt.

| Recherchenort DEN HAAG | Abschlußdatum der Recherche 06-04-1983 | Prüfer GYSEN L.A.D. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03.82